# FASCICULE DE BREVET EUROPEEN

(11) **EP 1 821 404 B1**
(45) Date de publication et mention de la délivrance du brevet: **10.04.2019**
(21) Numéro de dépôt: 07101542.4
(22) Date de dépôt: 01.02.2007
(51) Int. Cl.: H03F 3/60, H03F 1/42, H03F 3/62

(54) **Dispositif de couplage de signal haute fréquence**
Vorrichtung zur Kopplung von Hochfrequenzsignalen
Device for coupling a high-frequency signal

(30) Priorité: 20.02.2006 FR 0650577
(43) Date de publication de la demande: 22.08.2007
(73) Titulaire: Alcatel Lucent, 91620 Nozay (FR)
(72) Inventeur: Post, Georg, 91620 La Ville du Bois (FR); Meliani, Chafik, 12555 Berlin (DE)
(74) Mandataire: Nokia EPO representatives

(56) Documents cités:
- US-A- 5 365 197
- US-A- 5 550 513
- US-A- 6 094 099
- US-B1- 6 377 125
- THOMAS Y K WONG ET AL: "A 10 Gb/s AlGaAs/GaAs HBT High Power Fully Differential Limiting Distributed Amplifier for III-V Mach-Zehnder Modulator" IEEE JOURNAL OF SOLID-STATE CIRCUITS, IEEE SERVICE CENTER, PISCATAWAY, NJ, US, vol. 31, no. 10, octobre 1996 (1996-10), XP011060351 ISSN: 0018-9200

## Description

La présente invention concerne un dispositif de couplage de signal haute fréquence entre deux composants optoélectroniques alimentés par des tensions et courants de polarisation distincts.

Un modulateur à bande large, au moins pour 40Gbit/s, tel un Mach-Zender utilisé dans un système optoélectronique fonctionne avec une tension contrôlée crête à crête, par exemple de 6 Volts pour un modulateur de type Lithium-Niobate, superposée à une polarisation DC. Il est par ailleurs souvent intéressant d'utiliser un amplificateur pour fournir le signal d'entrée du modulateur.

Les amplificateurs et modulateurs sont généralement alimentés par des tensions et courants distincts. Par ailleurs, l'intégration sur un même composant d'un modulateur et d'un amplificateur pose des problèmes de couplage à cause des différences de polarisation en courant continu. Un dispositif de couplage intermédiaire est donc nécessaire.

Il est alors intéressant de minimiser les pertes en hyperfréquence (i.e. au-delà de 100kHz) dans le dispositif de couplage, à savoir dans les lignes de transmission du signal entre l'amplificateur et le modulateur. Ces pertes sont dues à la réflexion électro-magnétique du signal par l'apparition d'impédances et de capacités parasites en hyperfréquence. Il est alors nécessaire lorsque le signal à transférer est à haute fréquence (i.e. au-delà de 100kHz) d'adapter l'impédance du dispositif de couplage à celles des amplificateur et modulateur.

Le dispositif de couplage peut être un « T de polarisation » de laboratoire. Il comprend donc une capacité et une impédance. Le volume d'un tel dispositif empêche cependant toute intégration dans un circuit intégré monolithique hyperfréquence (désigné par le sigle MMIC pour « monolithic microwave integrated circuit » en anglais). Par ailleurs, un « T de polarisation » a généralement une faible largeur de bande ; il ne laisse en effet ni passer les basses fréquences (inférieures à 100 kHz), ni les hautes fréquences (supérieures à quelques GHz). Par ailleurs, il est très volumineux, si bien qu'il ne peut être utilisé dans des circuits intégrés.

Le dispositif de couplage peut aussi être une simple diode de décalage, à savoir une diode de semi-conducteur sous forme discrète. La diode dispose d'une chute de tension constante mais présente une capacité et une résistance de jonction qui limitent les bandes passantes larges. Avec un tel dispositif, la transmission n'est pas identique à hautes et basses fréquences. Ce dispositif ne peut être optimisé que pour l'un ou l'autre de ces domaines fréquentiels, et dans les deux cas induit des pertes considérables, dues à l'adaptation imparfaite aux impédances de source et de charge, réduisant ainsi les performances.

Le dispositif de couplage peut également être une simple capacité de couplage. Un tel dispositif entraîne cependant des pertes par réflexion, donc une limitation de la bande passante. De plus, l'utilisation d'une capacité de petite dimension que l'on pourrait intégrer sur un MMIC ne permet pas de transmettre les fréquences inférieures à 100kHz.

Les dispositifs de couplage précités sont dits passifs, i.e. non alimentés. Ils ne laissent pas passer toutes les hautes fréquences, requises dans des modulateurs, par exemple optoélectroniques. Ainsi, les fréquences entre quelques kHz et quelques dizaines de GHz ne passent pas. Ces dispositifs passifs sont également trop volumineux, notamment lorsqu'ils comprennent des impédances. Ils ne peuvent pas alors par exemple s'intégrer dans un MMIC.

La demande de brevet EP-A-1 271 767 divulgue des charges actives distribuées afin de polariser un amplificateur du signal d'entrée d'un modulateur. Néanmoins, un tel dispositif offre un couplage unidirectionnel, à savoir que seule la sortie de l'amplificateur est alimentée. Le modulateur doit être polarisé par un dispositif indépendant. En outre, le dispositif décrit dans ce document ne peut fournir qu'un courant positif, et non positif ou négatif. Par ailleurs, le dispositif décrit dans EP-A-1 271 767 comprend une résistance en sortie qui a pour fonction d'absorber les composantes haute-fréquence du signal transmis en contre-propagation mais induit des pertes dans le signal transmis. Le document de brevet US 6 377 125 divulgue un dispositif de couplage de signal à haute fréquence fournissant des tensions et courants d'alimentation aux plusieurs étages d'un amplificateur distribué.

Il existe donc un besoin pour un dispositif de couplage bidirectionnel, c'est-à-dire susceptible de transmettre un signal d'un premier composant à un second et vice versa sans modifier la structure du dispositif. Il existe également un besoin pour un dispositif de couplage avec une large bande passante, à savoir de quelques kHz à 40 GHz. Ce dispositif doit par ailleurs avoir une dimension lui permettant de s'intégrer dans des MMIC. Enfin, il doit être le plus universel possible en permettant de coupler en entrée et sortie les paires tension-courant souhaitées par l'utilisateur, quels que soient ces tensions et courants.

L'invention propose en conséquence un dispositif de couplage de signal à haute fréquence entre un premier composant et un second composant conforme à la revendication 1 annexée.

L'invention propose également un tel dispositif de couplage comprenant une pluralité de limiteurs de tension connectés aux première et seconde lignes de transmission et distribués le long de ces lignes de transmission.

L'invention peut également comprendre une ou plusieurs des spécificités suivantes :
- un limiteur de courant comprend une diode,
- un limiteur de courant comprend un miroir de courant,
- un limiteur de courant comprend un transistor,
- un limiteur de tension comprend une diode,
- un composant est électronique,
- un composant est optoélectronique,
- les première et seconde lignes de transmission sont couplées entre elles de manière capacitive,
- le dispositif de couplage selon l'invention est susceptible de s'intégrer au premier composant ou au second composant.

D'autres caractéristiques et avantages de l'invention apparaîtront à la lecture de la description détaillée qui suit des modes de réalisation de l'invention, donnés à titre d'exemple uniquement et en références aux dessins qui montrent :
- figure 1, un schéma fonctionnel du dispositif de couplage 1 selon l'invention ;
- figure 2, un schéma semi-fonctionnel du dispositif de couplage 1 selon l'invention.
L'invention propose un dispositif de couplage 1 de signal haute fréquence entre un premier composant 3 et un second composant 5. Lors de la transmission d'un signal haute fréquence entre ces composants 3, 5, ce dispositif de couplage 1 peut fournir une première paire tension-courant (Ve, le) de polarisation continue au premier composant 3. Ce dispositif de couplage 1 peut également fournir une seconde paire tension-courant (Vs, Is) de polarisation continue au second composant 5. Ainsi, lors de la transmission d'un tel signal, le dispositif de couplage 1 peut fournir une tension Ve et un courant de fonctionnement le spécifiques à un premier composant 3. De même, ce dispositif de couplage 1 peut également fournir une tension Vs et un courant Is spécifiques au second composant 5. Ces tensions ou courants désirés Ve, le, Vs, Is peuvent être quelconques, à savoir tant positifs que négatifs, continus ou alternatifs. Cette faculté de choix de tensions et courants Ve, le, Vs, Is fournis permet de s'affranchir de l'ordre des composants 3, 5 en entrée et en sortie du dispositif de couplage 1. Le dispositif de couplage 1 selon l'invention est donc bidirectionnel concernant la propagation du signal haute fréquence.

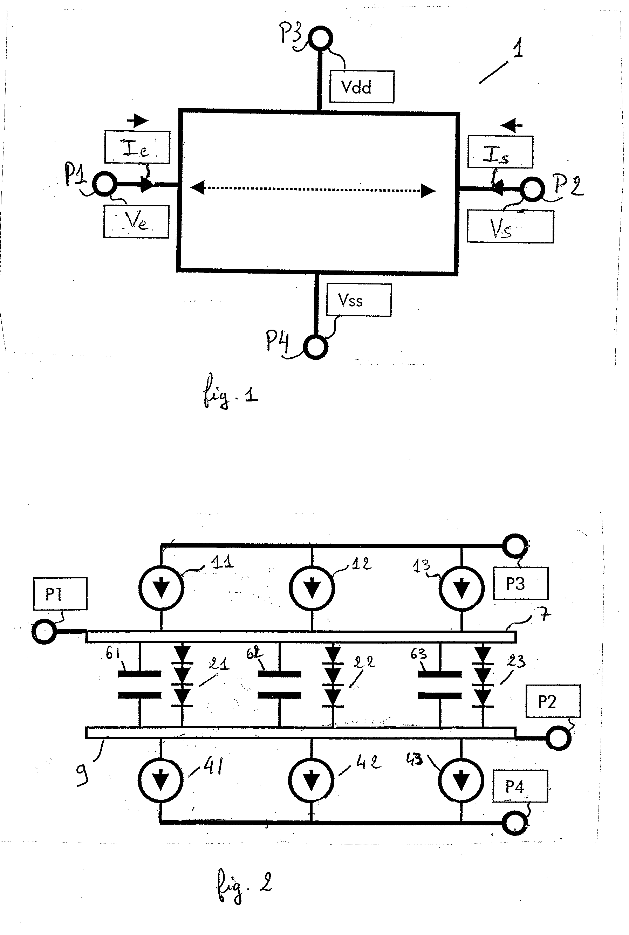

La figure 1 montre un schéma fonctionnel du dispositif de couplage 1 selon l'invention. Le dispositif de couplage 1 comprend un port d'entrée P1 et un port de sortie P2. Le port P1, respectivement P2, a une tension d'entrée Ve et un courant d'entrée le, respectivement une tension de sortie Vs et un courant de sortie Is. Les composants couplés 3, 5 (non représentés sur la figure 1) sont branchés aux ports d'entrée P1 et de sortie P2. Le dispositif de couplage 1 peut donc fonctionner dans les deux sens possibles de propagation du signal, soit du port P1 au port P2 et vice versa. Le dispositif de couplage 1 est alimenté par son premier port d'alimentation en tension P3 par une première tension continue Vdd et par son second port d'alimentation en tension P4 par une seconde tension continue Vss. Ces ports P3 et P4 sont connectés au potentiel d'un plan de masse, concernant les hautes fréquences.

Les notions générales suivantes seront utilisées dans l'exposé qui suit afin d'estimer les nombres et les dimensions des différents composants du dispositif.

Une *ligne de transmission sans perte* est un fil, un ruban ou un autre conducteur électrique caractérisé par une inductance L par unité de longueur et une capacité C par unité de longueur par rapport à un plan de masse.

L'*impédance caractéristique* Z de cette *ligne de transmission sans perte* est définie par Z² = L / C. Cette impédance caractéristique correspond à la valeur de résistance à connecter au bout de la ligne permettant de recevoir, sans perte par réflexion, tout signal électrique se propageant sur la ligne.

Si la ligne de transmission n'est pas continue mais plutôt une chaîne discontinue où se succèdent des inducteurs individuels d'inductance L (de petite dimension par rapport à la longueur totale) et des condensateurs individuels de capacité C, connectés à la masse, alors la structure sera appelée une *ligne de transmission artificielle.*

Cette ligne a les mêmes propriétés de propagation électromagnétique que la ligne continue équivalente, notamment la même impédance Z donnée par Z² = L / C, pourvu que les fréquences f des signaux soient limitées vers le haut, selon la formule (2 π f)² L C < 1. Ainsi, plus les inducteurs individuels d'inductance L et les condensateurs individuels de capacité C sont nombreux et de petite taille - donc de faible valeur -, plus la fréquence supérieure d'utilisation est élevée. La formule ci-dessus, associée aux connaissances technologiques sur les dispositifs issus de micro-fabrication, permet d'estimer les dimensions géométriques nécessaires afin d'atteindre une fréquence supérieure d'utilisation souhaitée.

La figure 2 montre un schéma semi-fonctionnel du dispositif de couplage 1 selon l'invention. Le dispositif de couplage 1 comprend un premier et un second ports d'alimentation P3 et P4. Le dispositif de couplage 1 comprend également une première ligne de transmission 7 en entrée de laquelle se trouve le port d'entrée P1. Le dispositif de couplage 1 comprend également une seconde ligne de transmission 9 en sortie de laquelle se trouve le port de sortie P2.

Les première et seconde lignes de transmission 7, 9 ont des polarisations distinctes liées par des limiteurs de tension 21, 22, 23 branchés entre ces deux lignes 7, 9. Les limiteurs de tension 21, 22, 23 créent donc une chute de tension. Ainsi, une fois une des deux tensions de ligne de transmission fixée, la tension de la seconde ligne de transmission pourra être choisie par variation des limiteurs de tension 21, 22, 23.

Les limiteurs de tension 21, 22, 23 sont distribués, i.e. régulièrement répartis, le long des deux lignes de transmission 7, 9 afin d'éviter toute perte lors de la transmission d'un signal à haute fréquence. Des condensateurs de couplage 61, 62, 63 sont également disposés à intervalle régulier entre les deux lignes. En effet, en fonctionnement à haute fréquence, des éléments de circuit isolés (des capacités vers la masse associées aux limiteurs de tension 21, 22, 23 ou aux condensateurs de couplage 61, 62, 63) entre les deux lignes de transmission 7, 9 créent des pertes par réflexion électromagnétique du signal haute fréquence transmis. Ces capacités et impédances parasites apparaissent moins lorsque ces éléments sont distribués en grand nombre tel que leurs valeurs électriques L et C satisfont avec la fréquence d'utilisation f la formule mentionnée ci-dessus. Ces capacités et impédances parasites apparaissent également moins lorsque l'impédance caractéristique du système formé par les deux lignes de transmission 7, 9 et les limiteurs de tension 21, 22, 23, prenant en compte les réactances des éléments distribués, est égale à celle du câble de transmission en entrée du dispositif de couplage 1. Ces capacités et impédances parasites apparaissent également moins lorsque l'impédance caractéristique du système formé par les deux lignes de transmission 7, 9 et les limiteurs de tension 21, 22, 23, prenant en compte les réactances des éléments distribués, est égale à celle du câble de transmission en sortie du dispositif de couplage 1. La formule Z² = L / C mentionnée ci-dessus pour l'impédance Z permet de dimensionner les éléments respectifs afin d'égaliser l'impédance des câbles de transmission d'entrée et de sortie. Cette égalité garantit l'absence de réflexion du signal transmis. Le câble de transmission en entrée correspond au fil connectant le premier composant 3 au dispositif de couplage 1. Le câble de transmission en sortie correspond au fil connectant le second composant 5 au dispositif de couplage 1.

Les limiteurs de tension 21, 22, 23 sont distribués en parallèle le long des deux lignes de transmission 7, 9. Les limiteurs de tension 21, 22, 23 sont nombreux et de petite taille de manière à avoir une fréquence de coupure supérieure à la fréquence maximale du signal à transmettre. Le nombre et la taille de ces limiteurs de tension 21, 22, 23 sont déterminé par la formule (2 π f)² L C < 1 comme expliqué ci-dessus. Si tel n'est pas le cas, la composante du signal au dessus de la fréquence de coupure ne sera pas transmise, à cause de la réflexion électro-magnétique.

C'est la fréquence de coupure haute souhaitée f pour le dispositif de couplage 1 (typiquement quelques dizaines de GHz) qui fixe le nombre de limiteurs de tension 21, 22, 23 utilisés de manière à ce que les valeurs L des inducteurs individuels d'inductance L et C des condensateurs individuels de capacité C pour chaque limiteur de tension 21, 22, 23 soient conformes à la formule (2 π f)² L C < 1. La taille au sens de la section active totale des limiteurs de tension 21, 22, 23 est fixée par la fréquence de coupure basse (quelques dizaines de kHz voire 0 Hz). Par exemple, si une fréquence basse de 10 kHz est suffisante, il suffit de choisir des limiteurs de tension 21, 22, 23 de faible dimension et de résistance série parasite relativement grande. En effet, ces résistances série parasite seront court-circuitées par les condensateurs de couplage 61, 62, 63 à haute fréquence. Pour atteindre une fréquence très basse, il convient d'augmenter la taille ou le nombre des limiteurs de tension 21, 22, 23 afin de minimiser l'effet de ces résistances série parasite, donc les pertes qu'elles induisent. L'impédance caractéristique est calculée comme pour une ligne de transmission artificielle formée d'une chaîne d'inducteurs et de condensateurs, cette ligne de transmission artificielle étant constituée des capacités parallèles des limiteurs de tension 21, 22, 23 et des inductances séries des lignes de transmission 7, 9 qui les relient.

La figure 2 montre également des premiers limiteurs de courant 11, 12, 13 entre le premier port P3 d'alimentation du dispositif de couplage 1 et la première ligne de transmission 7. Ces premiers limiteurs de courant 11, 12, 13 sont paramétrés afin d'alimenter les limiteurs de tension 21, 22, 23 d'un courant leur permettant le fonctionnement souhaité, i.e. qu'il opère la chute de tension désirée. Ces premiers limiteurs de courant 11, 12, 13 sont également paramétrés afin de fournir au port d'entrée P1 un courant d'entrée désiré le.

Ces premiers limiteurs de courant 11, 12, 13 sont régulièrement distribués afin de limiter les pertes en haute fréquence par l'apparition de capacités, résistances et impédances parasites isolées. Trois de ces premiers limiteurs de courant 11, 12, 13 sont représentés sur la figure 2. Leur nombre dépend de la fréquence de coupure haute souhaitée, cette fréquence de coupure étant calculée à partir de la formule (2 π f)² L C < 1 comme expliqué ci-dessus. Cette fréquence f de coupure haute souhaitée est une fonction décroissante de la capacité C des condensateurs individuels de chaque limiteur de tension 21, 22, 23 et de l'inductance L des inducteurs individuels des sections de ligne entre les éléments.

Similairement des seconds limiteurs de courant 41, 42, 43 sont placés entre la seconde ligne de transmission 9 et le second port d'alimentation P4. Ces seconds limiteurs de courant 41, 42, 43 sont paramétrés afin d'absorber le courant issu des limiteurs de tension 21, 22, 23. Ces seconds limiteurs de courant 41, 42, 43 sont également paramétrés afin de fournir au port de sortie P2 un courant d'entrée désiré Is.

Ces seconds limiteurs de courants 41, 42, 43 sont également régulièrement distribués afin de limiter les pertes en haute fréquence et en basse fréquence par l'apparition de capacités, résistances et impédances parasites. Ces seconds limiteurs de courants 41, 42, 43 gardent ainsi un coefficient de transmission (rapport de l'amplitude sortante sur l'amplitude entrante) constant en large bande. Trois de ces seconds limiteurs de courant 41, 42, 43 sont représentés sur la figure 2. Leur nombre dépend de la fréquence de coupure haute souhaitée comme dans le cas des limiteurs de courant 11, 12 et 13 susmentionnés.

Les premiers 11, 12, 13 comme les seconds 41, 42, 43 limiteurs de courant peuvent être des transistors. Ces transistors fournissent des courants constants indépendamment de la tension de la ligne de transmission à laquelle ils sont connectés (7 ou 9). Ces transistors permettent donc de régler le courant constant les traversant, même après leur installation. On peut utiliser indifféremment un transistor de type bipolaire ou à effet de champ, en fonction de la technologie du circuit micro électronique auquel le dispositif de couplage sera intégré.

Les premiers 11, 12, 13 comme les seconds 41, 42, 43 limiteurs de courant peuvent être également des diodes paramétrées en courant constant. Ces diodes sont plus simples à installer que les transistors. Ces diodes ne permettent pas de régler le courant les traversant après installation. Seul le remplacement de la diode par une autre ayant le courant de fonctionnement voulu est possible.

Les premiers 11, 12, 13 comme les seconds 41, 42, 43 limiteurs de courant peuvent être en outre des résistances limitatives. De telles résistances limitatives assurent ainsi la limitation du courant à partir d'une tension spécifique. Par ailleurs, de telles résistances limitatives s'installent simplement. Cependant, ces résistances limitatives ne permettent pas de régler le courant les traversant après installation.

Concernant les limiteurs de courant 11, 12, 13, 41, 42, 43, on peut aussi utiliser une technologie HBT (transistor bipolaire à hétérojonction) grâce à des circuits à miroir de courant. Ces circuits à miroir de courant permettent d'avoir des limiteurs de courant ajustables et dont la commande est bien découplée du signal haute fréquence transmis.

Un limiteur de tension 21, 22, 23 peut comprendre une diode. Cette diode crée la chute de tension désirée entre les deux lignes de transmission 7, 9. Le type de diode varie selon la technologie microélectronique. De préférence, cette diode fonctionne dans un régime de polarisation tel que sa résistance différentielle soit faible. Une diode pn par exemple implique d'avoir une tension plus élevée sur la première ligne de transmission 7 que sur la seconde ligne de transmission 9. Ceci est évité en utilisant une diode Zener, ce qui permet au dispositif de fonctionner de manière bidirectionnelle puisque les tensions d'entrée Ve et de sortie le pourront être supérieures l'une à l'autre selon l'alimentation en courant des diodes Zener.

Il est également possible d'utiliser plusieurs diodes en série pour un limiteur de tension 21, 22, 23. Ceci permet d'obtenir une chute de tension plus importante pour un même courant de fonctionnement du limiteur de tension. Par ailleurs, une diode ayant une tension de jonction fixe après sa fabrication, la chute de tension totale dépend du nombre de diode mises en série.

La figure 2 montre par ailleurs une ou plusieurs capacités de couplage 61, 62, 63 placées en parallèle des limiteurs de tension 21, 22, 23. Chacune de ces capacités 61, 62, 63 permet de limiter les pertes en haute fréquence. La composante continue du courant passera par les limiteurs de tension 21, 22, 23 tandis que la composante haute fréquence passera par la capacité de couplage 61, 62, 63. Ainsi, toute résistance parasite qui aurait pu apparaître en haute fréquence en série d'un limiteur de tension 21, 22, 23 et provoquer des pertes voit son influence limitée par la capacité de couplage 61, 62, 63 en parallèle. La capacité de couplage 61, 62, 63 absorbe en effet la composante haute fréquence du courant.

Ces capacités de couplage 61, 62, 63 sont distribuées le long des lignes de transmission 7, 9. Les nombre et valeur des capacités de couplage 61, 62, 63 sont fixés par les fréquences de coupure haute et basse souhaitées pour le dispositif. Pour la fréquence de coupure haute, cela découle de la formule (2 π f)² L C < 1 comme expliqué précédemment. La fréquence de coupure basse dépend de la résistance série de la combinaison parallèle des limiteurs de tension 21, 22, 23. La fréquence de coupure basse sera proche de zéro si une bonne technologie permet d'abaisser cette résistance nettement au dessous des impédances caractéristiques...

Ainsi, les lignes de transmission 7 et 9 sont couplées avec une faible impédance caractéristique, sous condition de la combinaison des limiteurs de tension 21, 22, 23 avec des condensateurs entre les lignes de transmission 7 et 9. Par conséquent, les impédances caractéristiques vis-à-vis des ports P1 et P2 sont sensiblement égales et sont déterminées par l'inductance par unité de longueur de l'ensemble des lignes et par la capacité par unité de longueur de l'ensemble des limiteurs de courant 11, 12, 13 ..., 41, 42, 43 ...

L'ensemble de ces composants utilisés pour les limiteurs de tension 21, 22, 23 et les limiteurs de courant 11, 12, 13, 41, 42, 43 sont de dimension de l'ordre du micromètre carré. Notamment aucune inductance, dont les dimensions sont souvent plus importantes que celles des autres composants, n'est utilisée. Il est donc possible de fabriquer de manière intégrée le dispositif de couplage 1. Ce dernier peut dès lors être intégré à un MMIC.

Ce dispositif de couplage 1 peut en outre être intégré dans le premier ou le second composant 3, 5. Il est avantageux de pouvoir choisir celui des deux dont les matériaux et les technologies sont le mieux adaptés.

Le dispositif de couplage 1 peut être utilisé pour coupler un amplificateur et un modulateur, mais également tout autre composant électronique ou optoélectronique. Ceci peut être un modulateur Mach-Zender, voire tout composant utilisant un signal hyperfréquence (à savoir de fréquence éventuellement supérieure à 1GHz). Deux amplificateurs peuvent donc être couplés par le présent dispositif de couplage 1. Ce couplage est facilité par la possibilité de choix des paires tensions courants en entrée et sortie Ve, le, Vs, Is du dispositif de couplage 1, et par là de l'impédance caractéristique du dispositif de couplage 1.

Le dispositif de couplage 1 peut être fabriqué à partir de technologies à haute vitesse III-V HEMT (transistor à grande mobilité d'électrons) sur des substrats semi-isolants ou toute autre technologie avec des lignes de transmission 7, 9 coplanaires. Des lignes coplanaires sont en l'espèce côte à côte et non l'une au dessus de l'autre. Aucun trou d'interconnexion à travers un substrat semi-isolant n'est ainsi requis. Ceci évite donc les perçages à travers le substrat pour relier des éléments de circuit à une tension neutre.

Les deux lignes de transmission 7, 9 peuvent être fabriquées sous forme de lignes couplées, l'une au dessus de l'autre et séparées par une fine couche d'isolant, comme du nitrure de silicium.

Le dispositif de couplage 1 de la présente invention permet le transfert d'un signal basse fréquence comme haute fréquence, i.e. un signal continu comme de fréquence au-delà de 100 MHz. Le dispositif de couplage 1 effectue ce transfert, et ce, sans perte et avec les avantages listés ci-dessus, voire ceux qui découlent clairement et sans ambiguïté de la présente demande à l'homme du métier.

## Revendications

1. Dispositif de couplage (1) de signal à haute fréquence entre un premier composant (3) et un second composant (5), adapté à fournir:
- une première paire tension courant de polarisation (Ve, le) au premier composant (3) ;
- une seconde paire tension courant de polarisation (Vs, Is) au second composant (5);
- le dispositif de couplage (1) comprenant une première et une seconde lignes de transmission (7, 9), **caractérisé en ce qu'**il comprend aussi:
- une première pluralité de limiteurs de courant (11, 12, 13) connectés à un premier port d'alimentation en tension (P3) et à la première ligne de transmission (7) et distribués le long de cette première ligne de transmission (7),
- une seconde pluralité de limiteurs de courant (41, 42, 43) connectés à un second port d'alimentation en tension (P4) et à la seconde ligne de transmission (9) et distribués le long de la seconde ligne de transmission (9).

2. Le dispositif selon la revendication 1, comprenant
- une pluralité de limiteurs de tension (21, 22, 23) connectés aux première et seconde lignes de transmission (7, 9) et distribués le long de ces lignes de transmission (7, 9).

3. Le dispositif selon la revendication 1, dans lequel un limiteur de courant (11, 12, 13, 41, 42, 43) comprend une diode.

4. Le dispositif selon la revendication 1, dans lequel un limiteur de courant (11, 12, 13, 41, 42, 43) comprend un miroir de courant.

5. Le dispositif selon la revendication 1, dans lequel un limiteur de courant (11, 12, 13, 41, 42, 43) comprend un transistor.

6. Le dispositif selon la revendication 2, dans lequel un limiteur de tension (21, 22, 23) comprend une diode.

7. Le dispositif selon l'une des revendications précédentes, dans lequel un composant est électronique.

8. Le dispositif selon l'une des revendications précédentes, dans lequel un composant est optoélectronique.

9. Le dispositif selon l'une des revendications 1 à 8, dans lequel les première et seconde lignes de transmission (7, 9) sont couplées entre elles de manière capacitive.

10. Le dispositif selon l'une des revendications précédentes, dans lequel le dispositif de couplage (1) est susceptible de s'intégrer au premier composant ou au second composant (3, 5).

## Patentansprüche

1. Vorrichtung (1) zur Kopplung von Hochfrequenzsignalen zwischen einer ersten Komponente (3) und einer zweiten Komponente (5), welche geeignet ist zu liefern:
- ein erstes Paar Spannung-Polarisationsstrom (Ve, Ie) an die erste Komponente (3);
- ein zweites Paar Spannung-Polarisationsstrom (Vs, Is) an die zweite Komponente (5);
- wobei die Kopplungsvorrichtung (1) eine erste und eine zweite Übertragungsleitung (7, 9) umfasst;
**dadurch gekennzeichnet, dass** diese auch umfasst:
- eine erste Vielzahl von Strombegrenzern (11, 12, 13), die mit einem ersten Spannungszufuhrport (P3) und mit der ersten Übertragungsleitung (7) verbunden sind und entlang dieser ersten Übertragungsleitung (7) verteilt sind;
- eine zweite Vielzahl von Strombegrenzern (41, 42, 43), die mit einem zweiten Spannungszufuhrport (P4) und mit der zweiten Übertragungsleitung (9) verbunden sind und entlang der zweiten Übertragungsleitung (9) verteilt sind.

2. Vorrichtung nach Anspruch 1, umfassend:
- eine Vielzahl von Spannungsbegrenzern (21, 22, 23), die mit der ersten und zweiten Übertragungsleitung (7, 9) verbunden sind und entlang dieser Übertragungsleitungen (7, 9) verteilt sind.

3. Vorrichtung nach Anspruch 1, wobei ein Strombegrenzer (11, 12, 13, 41, 42, 43) eine Diode umfasst.

4. Vorrichtung nach Anspruch 1, wobei ein Strombegrenzer (11, 12, 13, 41, 42, 43) einen Stromspiegel umfasst.

5. Vorrichtung nach Anspruch 1, wobei ein Strombegrenzer (11, 12, 13, 41, 42, 43) einen Transistor umfasst.

6. Vorrichtung nach Anspruch 2, wobei ein Spannungsbegrenzer (21, 22, 23) eine Diode umfasst.

7. Vorrichtung nach einem der vorhergehenden Ansprüche, wobei eine Komponente elektronisch ist.

8. Vorrichtung nach einem der vorhergehenden Ansprüche, wobei eine Komponente optoelektronisch ist.

9. Vorrichtung nach einem der Ansprüche 1 bis 8, wobei die erste und zweite Übertragungsleitung (7, 9) miteinander kapazitiv gekoppelt sind.

10. Vorrichtung nach einem der vorhergehenden Ansprüche, wobei die Kopplungsvorrichtung (1) in der ersten Komponente oder in der zweiten Komponente (3, 5) integriert sein kann.

## Claims

1. Device (1) for coupling a high-frequency signal between a first component (3) and a second component (5), designed to supply:
- a first bias voltage-current pair (Ve, Ie) to the first component (3);
- a second bias voltage-current pair (Vs, Is) to the second component (5);
- the coupling device (1) comprising a first and a second transmission line (7, 9), **characterized in that** it also comprises:
- a first plurality of current limiters (11, 12, 13) connected to a first voltage supply port (P3) and to the first transmission line (7) and distributed along this first transmission line (7),
- a second plurality of current limiters (41, 42, 43) connected to a second voltage supply port (P4) and to the second transmission line (9) and distributed along the second transmission line (9).

2. Device according to Claim 1, comprising
- a plurality of voltage limiters (21, 22, 23) connected to the first and second transmission lines (7, 9) and distributed along these transmission lines (7, 9).

3. Device according to Claim 1, wherein a current limiter (11, 12, 13, 41, 42, 43) comprises a diode.

4. Device according to Claim 1, wherein a current limiter (11, 12, 13, 41, 42, 43) comprises a current mirror.

5. Device according to Claim 1, wherein a current limiter (11, 12, 13, 41, 42, 43) comprises a transistor.

6. Device according to Claim 2, wherein a voltage limiter (21, 22, 23) comprises a diode.

7. Device according to one of the preceding claims, wherein a component is electronic.

8. Device according to one of the preceding claims, wherein a component is optoelectronic.

9. Device according to one of Claims 1 to 8, wherein the first and second transmission lines (7, 9) are capacitively coupled to one another.

10. Device according to one of the preceding claims, wherein the coupling device (1) is able to be integrated into the first component or into the second component (3, 5).
